# EUROPEAN PATENT APPLICATION

(11) **EP 4 246 544 A1**
(43) Date of publication of application: **20.09.2023**
(21) Application number: 21890904.2
(22) Date of filing: 19.10.2021
(51) Int. Cl.: H01G 4/224, H01G 4/33

(54) **THIN-FILM CAPACITOR CORE**

(30) Priority: 13.11.2020 CN 202011267506
(71) Applicant: Xiamen Faratronic Co., Ltd., Fujian 361022 (CN)
(72) Inventor: LIN, Jintao, Xiamen, Fujian 361022 (CN); LAN, Shaohan, Xiamen, Fujian 361022 (CN); ZHANG, Wengang, Xiamen, Fujian 361022 (CN)
(74) Representative: Cabinet Chaillot
(86) International application number: PCT/CN2021/124640
(87) International publication number: WO 2022/100377

(57) **Abstract**

A thin-film capacitor core that has a core body, a covering film and a sprayed metal coating provided at two ends of the core body to form electrodes. The covering film is wound around an outer circumferential surface of the core body; the covering film has a base film and a waterproof layer attached to the base film. A waterproof covering process for the thin-film capacitor core can be performed by means of winding using a winding machine for producing a core body, such that on the premise of ensuring production efficiency of the thin-film capacitor core, the moisture resistance of the thin-film capacitor core is improved. A thin-film capacitor loaded with the thin-film capacitor core, and a printed circuit board loaded with the thin-film capacitor are also provided.

## Description

### TECHNICAL FIELD

The present invention relates to the technical field of capacitors, and in particular to a thin-film capacitor core, a thin-film capacitor loaded with the thin-film capacitor core, and a printed circuit board loaded with the thin-film capacitor.

### BACKGROUND

Capacitors are one of the electronic components which are used great numbers in an electronic device, and is widely applied to aspects of blocking, coupling, bypassing, filtering, tuning loops, energy conversion, controlling circuits and the like, while a thin-film capacitor is widely applied to a PCB board circuit with circuit jumper line electromagnetic interference resistance and alternating current and direct current filtering. Most of the electric appliances and electrical devices operate in an indoor environment with better temperature and humidity conditions. However, with the development of new energy technologies, outdoor installation devices such as photovoltaic inverters and charging piles and the like are adopted, environment conditions where these devices are used are relatively severe, and their continuous operation time is long. Therefore, higher requirements for hot and humid reliability are proposed on the electronic components on a PCB board.

In related technologies, a core of a thin-film capacitor is additionally and manually coated by an aluminum foil, and that costs a large amount of manpower resources for production of the core of the thin-film capacitor, and production efficiency of the core of the thin-film capacitor is low; or, instead of coating the core of the thin-film capacitor, the thickness of a packaging material of the thin-film capacitor is increased, and a packaging material with better moisture resistance is used, in this way, although the moisture resistance of the thin-film capacitor may be improved, the resulting thin-film capacitor is too large in size, too expensive to produce, and lacks competitiveness.

### SUMMARY

The present invention aims to solving at least partially the technical problems in the above art. Therefore, one object of the present invention is to provide a thin-film capacitor core, which uses a covering film of the present invention to replace an original protective film of the thin-film capacitor core, such that a waterproof covering process for the thin-film capacitor core can be performed by means of winding using a winding machine for producing a core body, such that on the premise of ensuring production efficiency of the thin-film capacitor core, moisture resistance of the thin-film capacitor core is improved.

In order to achieve the above object, a first aspect of the present invention provides a thin-film capacitor core, comprising a core body, a covering film, and a sprayed metal coating; the covering film is wound around an outer circumferential surface of the core body, the covering film comprises a base film and a waterproof layer, the waterproof layer is attached to the base film, and the sprayed metal coating is applied to two end surfaces of the core body to form electrodes.

The thin-film capacitor core according to the present invention comprises a core body, a covering film and a sprayed metal coating, where the covering film is wound around an outer circumferential surface of the core body; the covering film comprises a base film and a waterproof layer; the waterproof layer is attached to the base film; the sprayed metal coating is applied to two end surfaces of the core body to form electrodes. A waterproof covering process for the thin-film capacitor core can be performed by means of winding using a winding machine for producing a core body. Accordingly, on the premise of ensuring production efficiency of the thin-film capacitor core, moisture resistance of the thin-film capacitor core is improved.

In addition, the thin-film capacitor core according to the present invention may also have the following additional technical features.

Optionally, the sprayed metal coating covers at least one outer side edge of the waterproof layer.

Optionally, the waterproof layer is a metal waterproof layer.

Optionally, the waterproof layer is a metal oxide waterproof layer.

Optionally, the waterproof layer is attached to a surface of the base film; the base film has a width equivalent to that of the core body; at least an area of the base film is left blank to form at least one blank area without any waterproof layer attached thereto so as to define at least one electrical clearance.

Optionally, said at least one blank area of the base film comprises a single blank area, and the single blank area extends around the outer circumferential surface of the core body.

Optionally, said at least one blank area on the base film comprises a plurality of blank areas, and the plurality of blank areas are evenly spaced along a lengthwise direction of the base film.

Optionally, the waterproof layer comprises a first waterproof layer and a second waterproof layer, the first waterproof layer and the second waterproof layer are attached to two opposite surfaces of the base film respectively, the base film has the width equivalent to that of the core body; said at least one blank area is formed on a surface of the base film attached with the first water proof layer to define said at least one electrical clearance on the surface of the base film attached with the first water proof layer, and said at least one blank area is also formed on a surface of the base film attached with the second waterproof layer to define said at least one electrical clearance on the surface of the base film attached with the second waterproof layer.

Optionally, the base film comprises a first base film and a second base film, the waterproof layer comprises a first waterproof layer and a second waterproof layer, where the first waterproof layer is attached to an outer surface of the first base film, the second waterproof layer is attached to an outer surface of the second base film, said at least one blank area is formed on the outer surface of the first base film attached with the first waterproof layer, and said at least one blank area is also formed on the outer surface of the second base film attached with the second waterproof layer, and said at least one blank area formed on the outer surface of the first base film attached with the first waterproof layer and said at least one blank area formed on the outer surface of the second base film attached with the second waterproof layer are arranged in a staggered manner.

Optionally, said at least one blank area formed on the outer surface of the first base film attached with the first waterproof layer comprises one single blank area positioned at a first end of the first base film, said at least one blank area formed on the outer surface of the second base film attached with the second waterproof layer comprises one single blank area positioned at a second end of the second base film, and the first end of the first base film is positioned opposite to the second end of the second base film.

Optionally, a gap is provided at each of two ends of the waterproof layer to space apart the two ends of the waterproof layer from the sprayed metal coating, and a width of each gap is smaller than a tolerance distance of the sprayed metal coating.

Optionally, the base film comprises a first base film and a second base film; the waterproof layer comprises a first waterproof layer and a second waterproof layer; the first waterproof layer is attached to an outer surface of the first base film, the second waterproof layer is attached to an outer surface of the second base film; the first base film and the first waterproof layer are of equal width; the second base film and the second waterproof layer are of equal width; a gap is provided between the sprayed metal coating and first ends of both the first base film and the first waterproof layer; a gap is also provided between the sprayed metal coating and second ends of both the second base film and the second waterproof layer; the first ends of the first base film and the first waterproof layer are opposite to the second ends of the second base film and the second waterproof layer.

In order to achieve the object of the present invention, the present invention also provides a thin-film capacitor which includes the above thin-film capacitor core.

According to the thin-film capacitor provided by the present invention loaded with the above thin-film capacitor core, the production efficiency of the thin-film capacitor can be ensured, also, the moisture resistance of the thin-film capacitor is improved, such that the thin-film capacitor is suitable for a high temperature and humid environment.

In order to achieve the object of the present invention, the present invention also provides a printed circuit board on which the above thin-film capacitor is loaded.

According to the printed circuit board provided by the present invention load with the above thin-film capacitor, the production efficiency of the printed circuit board is ensured, also, the moisture resistance of the printed circuit board is improved, such that the printed circuit board is suitable for the high temperature and humid environment.

### BRIEF DESCRIPTION OF THE DRAWINGS

FIG. 1 is a schematic structural diagram of a thin-film capacitor core according to an embodiment of the present invention;
FIG. 2 is a schematic structural diagram of a cross section of a thin-film capacitor core according to an embodiment of the present invention;
FIG. 3 is a schematic structural diagram of attaching a waterproof layer of the covering film on a single surface of the base film according to an embodiment of the present invention;
FIG. 4 is a schematic diagram of different ways of attaching a waterproof layer of the covering film on a single surface of the base film according to different embodiments of the present invention;
FIG. 5 is a schematic diagram of attaching the waterproof layer to different surfaces of the base film according to different embodiments of the present invention;
FIG. 6 is a schematic diagram of attaching a waterproof layer of the covering film on a single surface of the base film according to yet another embodiment of the present invention;
FIG. 7 is a schematic diagram of different ways of attaching a waterproof layer of the covering film on two opposite surfaces of the base film according to different embodiments of the present invention;
FIG. 8 is a schematic structural diagram of a covering film according to different embodiments of the present invention;
FIG. 9 is a schematic structural diagram of a covering film according to another embodiment of the present invention;
FIG. 10 is a schematic structural diagram of a covering film according to yet another embodiment of the present invention.

### DETAILED DESCRIPTION

Embodiments of the present invention are described in details below, with preferred examples being illustrated in the accompanying drawings, where the same or similar reference numerals indicate the same or similar elements or elements having the same or similar functions throughout all the drawings. The embodiments described below with reference to the accompanying drawings are illustrative and intended to explain the present invention only and should not be construed as limiting the present invention.

In the prior art, a core of a thin-film capacitor is mostly coated manually with an aluminum foil, but this costs a large amount of manpower resources for production of the core of the thin-film capacitor, and production efficiency of the core of the thin-film capacitor is low If coating of the core is abandoned, the resulting thin-film capacitor has poor moisture resistance and is difficult to be suitable for a high temperature and humid use environment. The thin-film capacitor core according to the embodiments of the present invention comprises a core body, a covering film and a sprayed metal coating, where the covering film is wound around an outer circumferential surface of the core body; the covering film comprises a base film and a waterproof layer; the waterproof layer is attached to the base film; the sprayed metal coating is applied to two end surfaces of the core body to form electrodes. A waterproof covering process for the thin-film capacitor core can be performed by means of winding using a winding machine for producing a core body. Accordingly, on the premise of ensuring production efficiency of the thin-film capacitor core, moisture resistance of the thin-film capacitor core is improved.

In order to better understand the above technical solution, exemplary embodiments of the present invention will be described in more detail below with reference to the accompanying drawings. While the exemplary embodiments of the present invention are shown in the accompanying drawings, it should be understood that the present invention may be embodied in various forms and should not be limited to the embodiments set forth herein. Rather, these embodiments are provided such that the present invention will be thoroughly understood, and will fully convey a scope of the present invention to those skilled in the art.

In order to better understand the above technical solution, the above technical solution is described in detail in the following with reference to the accompanying drawings of the specification and specific embodiments.

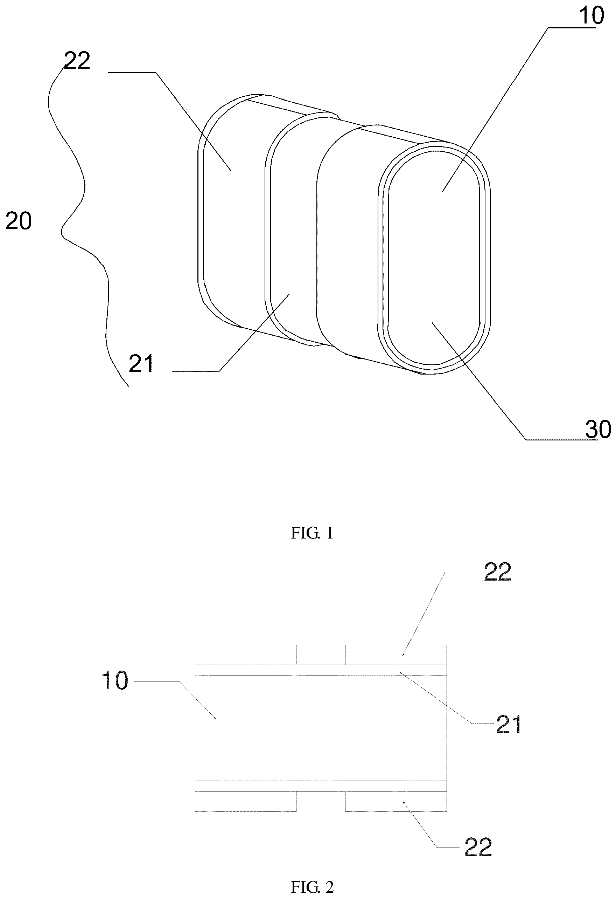

FIG. 1 is a schematic structural diagram of a thin-film capacitor core according to an embodiment of the present invention, and as shown in FIG. 1, the thin-film capacitor core comprises a core body 10, a covering film 20, and a sprayed metal coating 30.

Where the covering film 20 is wound around an outer circumferential surface of the core body 10, the covering film 20 comprises a base film 21 and a waterproof layer 22, the waterproof layer 22 is attached to the base film 21, and the sprayed metal coating 30 is applied to two end surfaces of the core body 10 to form electrodes. Therefore, the covering film 20 can be directly wound on the core body 10 by using a winding machine for producing the core body of the thin-film capacitor, and further, the winding operation does not need to increase any extra expenditure, and meanwhile, the moisture resistance and humidity resistance of the thin-film capacitor core are ensured, such that the thin-film capacitor core is suitable for use in a high temperature and humid working environment.

In some embodiments, the sprayed metal coating 30 covers at least one outer side edge of the waterproof layer 22, such that the sprayed metal coating 30 is tightly in contact with the waterproof layer 22 and thus prevents moisture from permeating into the core body 10 through an edge of the sprayed metal coating 30, thereby further improving the moisture resistance of the thin-film capacitor core.

It should be noted that the waterproof layer 22 may be a metal waterproof layer, or may be a metal oxide waterproof layer, and when the waterproof layer 22 is the metal waterproof layer, at least one electrical clearance needs to be formed to prevent short circuit.

When the waterproof layer 22 is the metal waterproof layer, the waterproof layer 22 may be attached to the base film 21 in various manners.

In some embodiments, as shown in FIG. 2, the waterproof layer 22 is attached to a surface of the base film 21; the base film 21 has a width equivalent to that of the core body 10 to secure a waterproof effect of the covering film 20, and at least an area of the base film 21 is left blank to form at least one blank area without any waterproof layer 22 attached thereto to define said at least one electrical clearance.

Said at least one blank area may be provided in various manners.

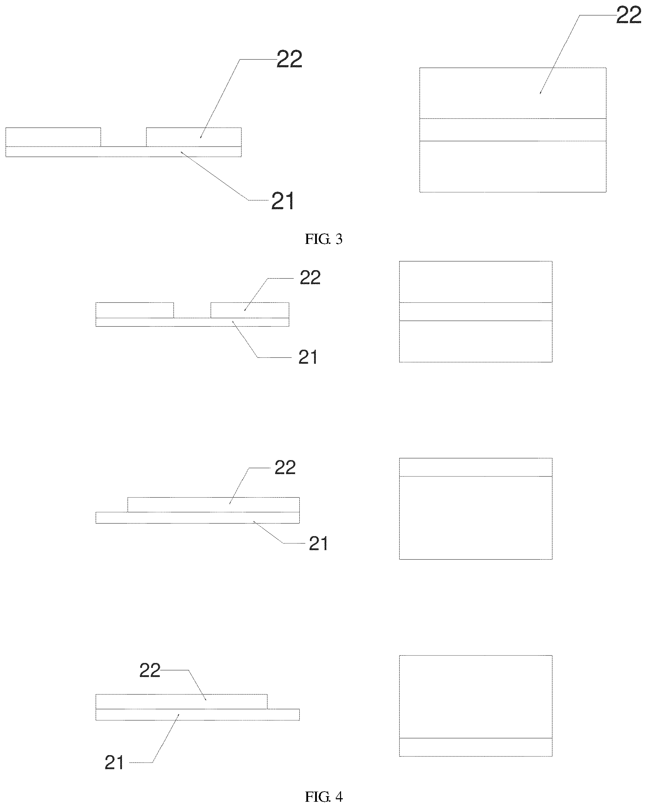

As an example, as shown in FIGs. 1 and 3, said at least one blank area of the base film 21 comprises a single blank area, and the single blank area extends around the outer circumferential surface of the core body 10. It should be noted that, as shown in FIG. 4, the single blank area may be provided at different positions, for example, the single blank area is positioned in a middle of the base film 21; or the single blank area is positioned at an end of the base film 21.

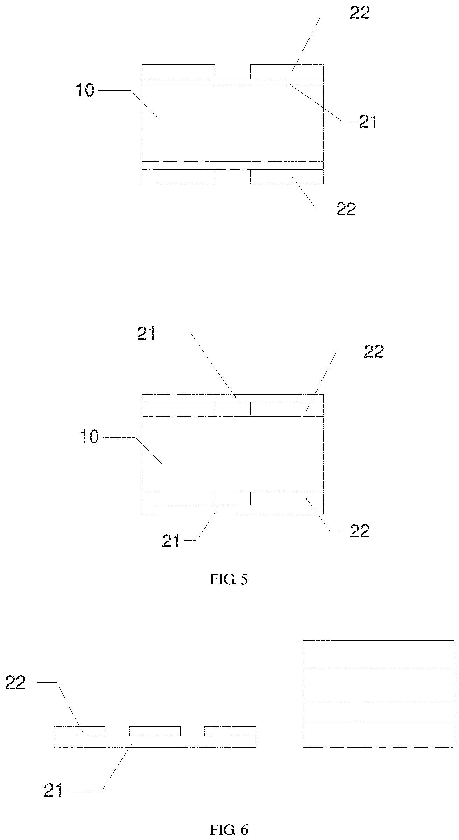

It should be noted that, as shown in FIG. 5, in a process of attaching the waterproof layer 22 to the surface of the base film 21, the waterproof layer 22 may be provided on a surface of the base film 21 proximal to the core body 10, or may be provided on a surface of the base film 21 away from the core body 10, and the thin-film capacitor core claimed by the present invention does not limit on which surface of the base film 21 the waterproof layer 22 should be attached. Moreover, the single blank area preferably has a rectangular sectional shape, but may also have any other shapes provided that the formation of said at least one electrical clearance is not affected.

As another example, as shown in FIG. 6, said at least one blank area on the base film 21 comprises a plurality of blank areas, and the plurality of blank areas are evenly spaced along a lengthwise direction of the base film 21.

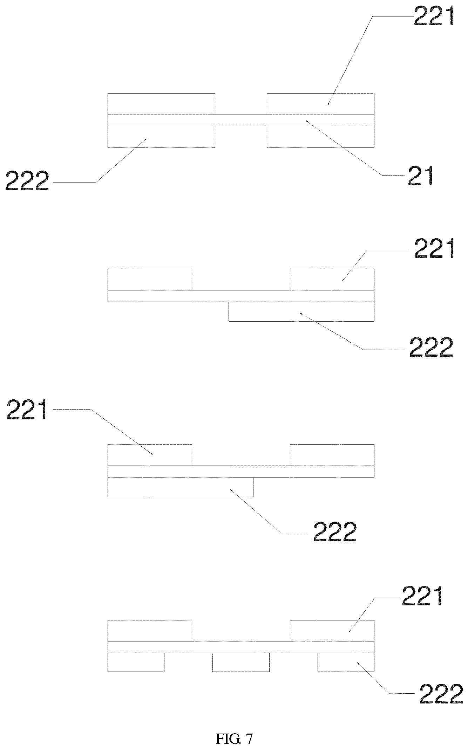

In some embodiments, as shown in FIG. 7, the waterproof layer 22 comprises a first waterproof layer 221 and a second waterproof layer 222, the first waterproof layer 221 and the second waterproof layer 222 are attached to two opposite surfaces of the base film 21 respectively, the base film 21 has the width equivalent to that of the core body 10; said at least one blank area is formed on a surface of the base film 21 attached with the first water proof layer 221 to define said at least one electrical clearance on the surface of the base film 21 attached with the first water proof layer 221, and said at least one blank area is also formed on a surface of the base film 21 attached with the second waterproof layer 222 to define said at least one electrical clearance on the surface of the base film 21 attached with the second waterproof layer 222.

It can be understood that as described above in the description and shown in FIG. 3-6 in which the waterproof layer 22 is attached to one surface of the base film 21, the waterproof layer 22 may be attached to the base film 21 in various manners. Analogously, there may also be various ways to attach the first water proof layer 221 and the second waterproof layer 222 to said two opposite surfaces of the base film 21 respectively. For example, as shown in FIG. 7, said at least one blank area on the surface of the base film 21 attached with the first waterproof layer 221 comprises one single blank area positioned in the middle of the base film 21, and said at least one blank area on the surface of the base film 21 attached with the second waterproof layer 222 comprises also one single blank area positioned in the middle of the base film 21; or, said at least one blank area on the surface of the base film 21 attached with the first waterproof layer 221 comprises one single blank area positioned in the middle of the base film 21, and said at least one blank area on the surface of the base film 21 attached with the second waterproof layer 222 comprises one single blank area positioned at an end of the base film 21; or, said at least one blank area on the surface of the base film 21 attached with the first waterproof layer 221 comprises one single blank area positioned in the middle of the base film 21, and said at least one blank area on the surface of the base film 21 attached with the second waterproof layer 222 comprises a plurality of blank areas in rectangular sectional shapes space part from each other along a lengthwise direction of the base film 21. It can be understood that the moisture resistance of the thin-film capacitor core after winding the covering film 20 may be further improved by attaching said two opposite surfaces of the base film 21 with the first waterproof layer 221 and the second waterproof layer 222 respectively.

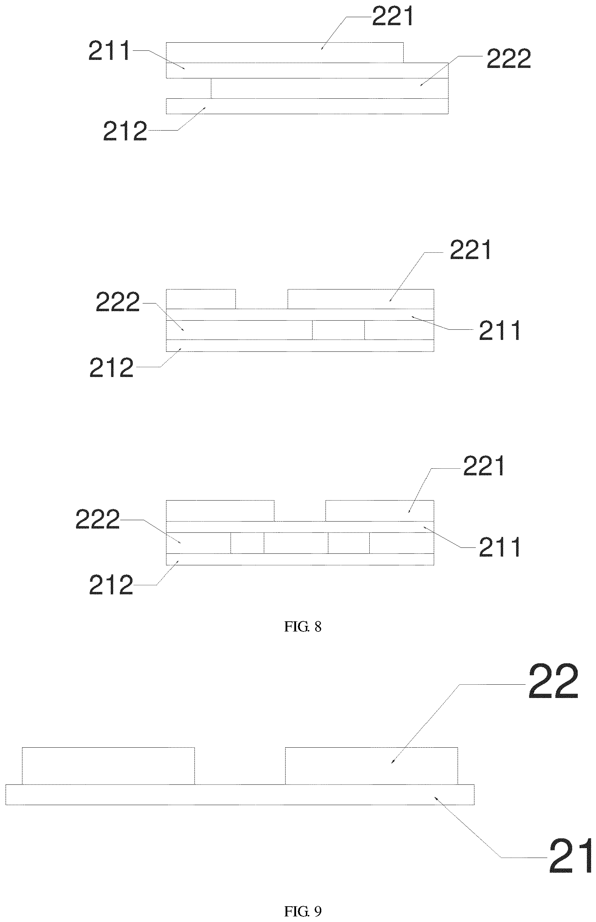

In some embodiments, as shown in FIG. 8, in order to further improve the moisture resistance of the thin-film capacitor core provided by the embodiments of the present invention, the base film 21 comprises a first base film 211 and a second base film 222, the waterproof layer 22 comprises a first waterproof layer 221 and a second waterproof layer 222, where the first waterproof layer 221 is attached to an outer surface of the first base film 211, the second waterproof layer 222 is attached to an outer surface of the second base film 212, said at least one blank area is formed on the outer surface of the first base film 211 attached with the first waterproof layer 221, and said at least one blank area is also formed on the outer surface of the second base film 212 attached with the second waterproof layer 222, and said at least one blank area formed on the outer surface of the first base film 211 attached with the first waterproof layer 221 and said at least one blank area formed on the outer surface of the second base film 212 attached with the second waterproof layer 222 are arranged in a staggered manner. It can be understood that by such a staggered arrangement, a complementary relationship may be formed between the first waterproof layer 221 and the second waterproof layer 222, thereby making it difficult for electric ions to penetrate into an interior of the core body 10, thus further improving the moisture resistance.

It should be noted that in order to improve the moisture resistance, the first base film 211, the second base film 222, the first waterproof layer 221, and the second waterproof layer 222 may be arranged in various manners.

As an example, as shown in FIG. 8, said at least one blank area formed on the outer surface of the first base film 211 attached with the first waterproof layer 221 comprises one single blank area positioned at a first end of the first base film 211, said at least one blank area formed on the outer surface of the second base film 212 attached with the second waterproof layer 222 comprises one single blank area positioned at a second end of the second base film 212, and the first end of the first base film 211 is positioned opposite to the second end of the second base film 212, so that the single blank area on the outer surface of the first base film 211 attached with the first waterproof layer 221 and the single blank area on the outer surface of the second base film 212 attached with the second waterproof layer 222 are staggered such that the first waterproof layer 221 and the second waterproof layer 222 form a complementary relationship.

As another example, as shown in FIG. 8, said at least one blank area formed on the outer surface of the first base film 211 attached with the first waterproof layer 221 comprises one single blank area positioned at proximal to one end of the first base film 211, said at least one blank area formed on the outer surface of the second base film 212 attached with the second waterproof layer 222 comprises one single blank area positioned proximal to one end of the second base film 212 wherein said one end of the second base film 212 is positioned opposite to the said one end of the first base film 211, so that the single blank area on the outer surface of the first base film 211 attached with the first waterproof layer 221 and the single blank area on the outer surface of the second base film 212 attached with the second waterproof layer 222 are staggered such that the first waterproof layer 221 and the second waterproof layer 222 form a complementary relationship.

As yet another example, as shown in FIG. 8, said at least one blank area formed on the outer surface of the first base film 211 attached with the first waterproof layer 221 comprises one single blank area positioned in the middle of the first base film 211, said at least one blank area formed on the outer surface of the second base film 212 attached with the second waterproof layer 222 comprises a plurality of blank areas spaced apart evenly along a lengthwise direction of the second base film 212, and the single blank area on the outer surface of the first base film 211 attached with the first waterproof layer 221 and the plurality of blank areas on the outer surface of the second base film 212 attached with the second waterproof layer 222 are staggered such that the first waterproof layer 221 and the second waterproof layer 222 form a complementary relationship.

In some embodiments, as shown in FIG. 9, a gap is provided at each of two ends of the waterproof layer 20 to space apart the two ends of the waterproof layer 20 from the sprayed metal coating, and a width of each gap is smaller than a tolerance distance of the sprayed metal coating, in other words, the sprayed metal coating has a certain tolerance distance, such that the two ends of the waterproof layer 20 are not necessarily flush with two ends of the core body 10.

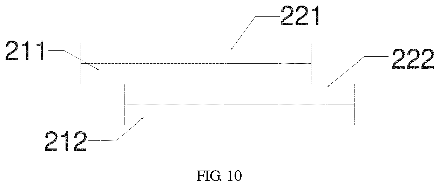

In some embodiments, as shown in FIG. 10, the base film 21 comprises a first base film 211 and a second base film 212; the waterproof layer 22 comprises a first waterproof layer 221 and a second waterproof layer 222; the first waterproof layer 221 is attached to an outer surface of the first base film 211, the second waterproof layer 222 is attached to an outer surface of the second base film 212; the first base film 211 and the first waterproof layer 221 are of equal width; the second base film 212 and the second waterproof layer 222 are of equal width; a gap is provided between the sprayed metal coating and first ends of both the first base film 211 and the first waterproof layer 221, so as to form an electrical clearance through the gap; and a gap is also provided between the sprayed metal coating and second ends of both the second base film 212 and the second waterproof layer 222, so as to form an electrical clearance through the gap; the first ends of the first base film 211 and the first waterproof layer 221 are opposite to the second ends of the second base film 212 and the second waterproof layer 222, such that a waterproof structure formed by the first base film 211 and the first waterproof layer 221 and a waterproof structure formed by the second base film 212 and the second waterproof layer 222 are complementary to each other.

In order to better illustrate an effect of improving moisture resistance provided by the thin-film capacitor core according to the embodiments of the present invention, a thin-film capacitor loaded with the thin-film capacitor core according to the embodiments of the present invention, and a common thin-film capacitor without any covering film of are teste under the same conditions wherein 275 VAC alternating voltage is continuously applied for 1000 hours under a damp and heat conditions of 85 < and 85% RH(relative humidity) are shown in the following table:

| Test subject | Comparison of capacity change after moisture resistance test |
|---|---|
| Thin-film capacitor loaded with thin-film capacitor core according to the present invention | Average change rate of capacity after test: -1.5% |
| Uncovered common thin-film capacitor | Average change rate of capacity after test: -7.7% |

In summary, the thin-film capacitor core according to the embodiments of the present invention comprises a core body, a covering film and a sprayed metal coating, where the covering film is wound around an outer circumferential surface of the core body; the covering film comprises a base film and a waterproof layer; the waterproof layer is attached to the base film; the sprayed metal coating is applied to two end surfaces of the core body to form electrodes. A waterproof covering process for the thin-film capacitor core can be performed by means of winding using a winding machine for producing a core body. Accordingly, on the premise of ensuring production efficiency of the thin-film capacitor core, moisture resistance of the thin-film capacitor core is improved.

In order to achieve the above embodiments, the present invention also provides a thin-film capacitor including the above thin-film capacitor core.

According to the thin-film capacitor provided by the present invention loaded with the above thin-film capacitor core, the production efficiency of the thin-film capacitor can be ensured, also, the moisture resistance of the thin-film capacitor is improved, such that the thin-film capacitor is suitable for a high temperature and humid environment.

In order to achieve the present invention, the present invention also provides a printed circuit board on which the above thin-film capacitor is loaded.

According to the printed circuit board provided by the present invention load with the above thin-film capacitor, the production efficiency of the printed circuit board is ensured, also, the moisture resistance of the printed circuit board is improved, such that the printed circuit board is suitable for the high temperature and humid environment.

In the description of the present invention, it should be understood that orientations or positional relationships indicated by the terms "center", "vertical", "horizontal", "length", "width", "thickness" "upper", "lower", "front", "rear", "left", "right", "vertical", "horizontal", "top", "bottom", "inner", "outer", "clockwise", "counterclockwise" and the like are orientations or positional relationships as shown in the drawings, and are only for the purpose of facilitating and simplifying the description of the present invention instead of indicating or implying that devices or elements indicated must have particular orientations, or be constructed and operated in the particular orientations. Such terms shall not be construed as limiting the present invention.

In addition, the terms "first" and "second" are only for the purpose of description, and may not be construed as indicating or implying the relative importance or implicitly indicating the number of technical features indicated. Thus, features defined by "first" and "second" may explicitly or implicitly include one or more of that feature. In the description of the present invention, "plurality" refers to two or more, unless otherwise explicitly and specifically defined.

In the embodiments of the present invention, unless otherwise explicitly specified and limited, the terms such as "mount", "connect", "link", "fix" and the like should be interpreted in a broad sense. For example, it may be a fixed connection, a detachable connection or integration; may be a mechanical connection or an electric connection; or may be a direct connection, an indirect connection by means of an intermediate, an internal interconnection of two elements or an interaction of two elements. For those of ordinary skill in the art, the specific meanings of the above terms in the present invention can be construed according to specific situations.

In the present invention, unless otherwise specified and limited, a first feature "on" or "under" a second feature may include the first and second features being in direct contact, and may also include the first and second features being not in direct contact, but being in contact via another feature between them. Moreover, a first feature "on", "above" and "over" a second feature includes a first feature being directly above and obliquely above a second feature, or simply indicating that a horizontal height of a first feature is higher than that of a second feature. A first feature "beneath", "under" and "below" a second feature includes a first feature being directly under and obliquely under a second feature, or simply indicating that a horizontal height of a first feature is smaller than that of a second feature.

In the description of the present specification, reference to the description of "one embodiment", "some embodiments", "an example", "a specific example", or "some examples" and the like means that a particular feature, structure, material, or characteristic described in connection with the embodiments or examples is included in at least one embodiment or example of the present invention. In the present specification, schematic expressions of the above terms should not be understood as necessarily referring to the same embodiments or examples. Moreover, particular features, structures, materials, or characteristics described may be combined in any suitable manner in any one or more embodiments or examples. Moreover, various embodiments or examples described in the present specification may be joined and combined by those skilled in the art.

Although the embodiments of the present invention have been shown and described above, it will be understood that the above embodiments are exemplary and not to be construed as limiting the present invention, and that changes, modifications, substitutions and alterations can be made to the above embodiments by those of ordinary skill in the art within the scope of the present invention.

## Claims

1. A thin-film capacitor core, comprising a core body (10), a covering film (20), and a sprayed metal coating (30); the covering film (20) is wound around an outer circumferential surface of the core body (10), the covering film (20) comprises a base film (21) and a waterproof layer (22), the waterproof layer (22) is attached to the base film (21), and the sprayed metal coating (30) is applied to two end surfaces of the core body (10) to form electrodes.

2. The thin-film capacitor core of claim 1, wherein the sprayed metal coating (30) covers at least one outer side edge of the waterproof layer (22).

3. The thin-film capacitor core of claim 1 or 2, wherein the waterproof layer (22) is a metal waterproof layer.

4. The thin-film capacitor core of claim 1 or 2, wherein the waterproof layer (22) is a metal oxide waterproof layer.

5. The thin-film capacitor core of claim 3, wherein the waterproof layer (22) is attached to a surface of the base film (21); the base film (21) has a width equivalent to that of the core body (10); at least an area of the base film (21) is left blank to form at least one blank area without any waterproof layer (22) attached thereto so as to define at least one electrical clearance.

6. The thin-film capacitor core of claim 5, wherein said at least one blank area of the base film (21) comprises a single blank area, and the single blank area extends around the outer circumferential surface of the core body (10).

7. The thin-film capacitor core of claim 5, wherein said at least one blank area on the base film (21) comprises a plurality of blank areas, and the plurality of blank areas are evenly spaced along a lengthwise direction of the base film (21).

8. The thin-film capacitor core of claim 3, wherein the waterproof layer (22) comprises a first waterproof layer (221) and a second waterproof layer (222), the first waterproof layer (221) and the second waterproof layer (222) are attached to two opposite surfaces of the base film (21) respectively, the base film (21) has a width equivalent to that of the core body (10); at least one blank area is formed on a surface of the base film (21) attached with the first water proof layer (221) to define at least one electrical clearance on the surface of the base film (21) attached with the first water proof layer (221), and at least one blank area is also formed on a surface of the base film (21) attached with the second waterproof layer (222) to define at least one electrical clearance on the surface of the base film (21) attached with the second waterproof layer (222).

9. The thin-film capacitor core of claim 3, wherein the base film (21) comprises a first base film (211) and a second base film (212), the waterproof layer (22) comprises a first waterproof layer (221) and a second waterproof layer (222), where the first waterproof layer (221) is attached to an outer surface of the first base film (211), the second waterproof layer (222) is attached to an outer surface of the second base film (212), at least one blank area is formed on the outer surface of the first base film (211) attached with the first waterproof layer (221), and at least one blank area is also formed on the outer surface of the second base film (212) attached with the second waterproof layer (222), and said at least one blank area formed on the outer surface of the first base film (211) attached with the first waterproof layer (221) and said at least one blank area formed on the outer surface of the second base film (212) attached with the second waterproof layer (222) are arranged in a staggered manner.

10. The thin-film capacitor core of claim 7, wherein said at least one blank area formed on the outer surface of the first base film (211) attached with the first waterproof layer (221) comprises one single blank area positioned at a first end of the first base film (211), said at least one blank area formed on the outer surface of the second base film (212) attached with the second waterproof layer (222) comprises one single blank area positioned at a second end of the second base film (212); the first end of the first base film (211) is positioned opposite to the second end of the second base film (212).

11. The thin-film capacitor core of claim 1, wherein a gap is provided at each of two ends of the waterproof layer (22) to space apart the two ends of the waterproof layer (22) from the sprayed metal coating (30), and a width of each gap is smaller than a tolerance distance of the sprayed metal coating (30).

12. The thin-film capacitor core of claim 1, wherein the base film (21) comprises a first base film (211) and a second base film (212); the waterproof layer (22) comprises a first waterproof layer (221) and a second waterproof layer (222); the first waterproof layer (221) is attached to an outer surface of the first base film (211), the second waterproof layer (222) is attached to an outer surface of the second base film (212); the first base film (211) and the first waterproof layer (221) are of equal width; the second base film (212) and the second waterproof layer (222) are of equal width; a gap is provided between the sprayed metal coating (30) and first ends of both the first base film (211) and the first waterproof layer (221); a gap is also provided between the sprayed metal coating (30) and second ends of both the second base film (212) and the second waterproof layer (222); the first ends of the first base film (211) and the first waterproof layer (221) are opposite to the second ends of the second base film (212) and the second waterproof layer (222).

13. A thin-film capacitor, comprising the thin-film capacitor core as claimed in any one of claims 1-12.

14. A printed circuit board, comprising the thin-film capacitor as claimed in claim 13.
